# EUROPÄISCHE PATENTSCHRIFT

(11) **EP 0 907 928 B1**
(45) Veröffentlichungstag und Bekanntmachung des Hinweises auf die Patenterteilung: **12.12.2001**
(21) Anmeldenummer: 97931650.2
(22) Anmeldetag: 24.06.1997
(51) Int. Cl.: G06K 19/077

(54) **SYSTEMTRÄGER FÜR DIE MONTAGE EINER INTEGRIERTEN SCHALTUNG IN EINEM SPRITZGUSSGEHÄUSE**
LEADFRAME FOR THE ASSEMBLY OF AN INTEGRATED CIRCUIT IN AN INJECTION MOUNDED HOUSING
GRILLE DE CONNEXION POUR LE MONTAGE D'UN CIRCUIT INTEGRE DANS UN BOITIER MOULE PAR INJECTION

(30) Priorität: 24.06.1996 DE 19625228
(43) Veröffentlichungstag der Anmeldung: 14.04.1999
(73) Patentinhaber: Infineon Technologies AG, 81669 München (DE)
(72) Erfinder: HAUSER, Christian, D-93049 Regensburg (DE); SCHMIDT, Helge, D-67346 Speyer (DE); WINDERL, Johann, D-92431 Neunburg (DE)
(74) Vertreter: Fischer, Volker, Dipl.-Ing.
(86) Internationale Anmeldenummer: DE9701314
(87) Internationale Veröffentlichungsnummer: WO9750056

(56) Entgegenhaltungen:
- EP-A- 0 277 854
- EP-A- 0 340 100
- "COMPOSITE CARD TO PROVIDE UNIFORM COOLING TO SINGLE CHIP MODULES WITH LARGE Z TOLERANCE" IBM TECHNICAL DISCLOSURE BULLETIN, Bd. 36, Nr. 6A, 1.Juni 1993, Seiten 333-334, XP000372450
- "TECHNIQUE FOR THERMALLY ENHANCING TAB" IBM TECHNICAL DISCLOSURE BULLETIN, Bd. 33, Nr. 3A, 1.August 1990, Seiten 354-356, XP000123971

## Beschreibung

Die Erfindung betrifft einen Systemträger für die Montage einer integrierten Schaltung in einem Spritzgußgehäuse, wobei der Systemträger einen Lead (dies ist ein Leiterelement für die Kontaktierung der integrierten Schaltung) aufweist, der mit einer Kontaktfläche versehen ist, die nach Fertigstellung des Spritzgußgehäuses ein äußerer Kontakt desselben für die Kontaktierung der integrierten Schaltung von außerhalb des Gehäuses ist.

Insbesondere wenn das Spritzgußgehäuse die Form einer Chipkarte oder dergleichen aufweist, ist es teilweise erwünscht, daß sich die Kontaktflächen nicht in unmittelbarer Nähe der integrierten Schaltung im Spritzgußgehäuse befinden. Dies führt dazu, daß die Leads sich relativ weit innerhalb des Gehäuses bzw. an dessen Oberfläche erstrecken. Die Herstellung erfolgt gewöhnlich durch ein zweiteiliges Spritzwerkzeug, welches einen Hohlraum aufweist, in den die integrierte Schaltung mit dem mit ihr verbundenen Systemträger eingebracht wird. Dabei ist die integrierte Schaltung für gewöhnlich mit einer duroplastischen Umhüllung (dem sogenannten Moldkörper) versehen, aus dem die Leads mit den Kontaktflächen herausragen. Beim sogenannten In-Mold-Labeling werden an zwei Seiten des im Spritzwerkzeuges gebildeten Hohlraumes je eine Dekorfolie bzw. ein Label angebracht. Zwischen den beiden Dekorfolien und in direktem Kontakt mit diesen befindet sich die Umhüllung der integrierten Schaltung. Der eigentliche Kartenkörper wird nun durch Einpressen eines thermoplastischen Kunststoffes in den verbleibenden Hohlraum zwischen den beiden Dekorfolien erzeugt.

Hierbei kann es zu zwei unerwünschten Effekten kommen: Zum einen können die relativ langen, aus der Umhüllung der integrierten Schaltung herausragenden Leads durch das Einspritzen der thermoplastischen Kunststoffmasse bei einem relativ hohen Einspritzdruck (teilweise weit über 1000 bar) verformt werden. Zum anderen besteht die Gefahr einer sogenannten Flash-Bildung auf den Kontaktflächen der Leads, bei der sich auf den Kontaktflächen ein dünner Film der thermoplastischen Kunststoffmasse bildet. Dies ist natürlich von Nachteil, da für eine spätere Kontaktierung der Kontaktflächen diese Kunststoff frei sein müssen. Für eine nachträgliche Entfernung des Flashs wird durch einen Reinigungsprozeß der dünne Kunststoffilm von den Kontaktflächen wieder abgelöst. Eine andere bekannte Möglichkeit, die Flash-Bildung zu verhindern, ist der Einsatz von dünnen Niederhaltestiften, die Bestandteile des Spritzwerkzeuges sind und beim Zusammenfügen der Spritzwerkzeughälften durch den von diesem gebildeten Hohlraum hindurch die Kontaktflächen gegen eine der Innenwände des Spritzwerkzeuges drücken. Auf diese Weise wird verhindert, daß thermoplastischer Kunststoff auf diejenige Seite der Kontaktfläche gelangt, die mit der Spritzwerkzeuginnenseite in Kontakt stehen. Der Einsatz dieser Niederhaltestifte hat jedoch den Nachteil, daß nach dem Einspritzen der Kunststoffmasse in den Hohlraum und dem anschließenden Entfernen der Niederhaltestifte Löcher im hergestellten Spritzgußgehäuse zurückbleiben.

In der EP 0 277 854 A1 ist ein Verfahren zur Herstellung von Chipkarten beschrieben, bei dem ein Spritzwerkzeug mit auf der Innenseite vorstehenden Noppen, die in Aussparungen des Leads eingreifen, verwendet wird. Durch einen Ansaugkanal wird ein Unterdruck zwischen dem Chip und der Innenseite des Spritzwerkzeuges erzeugt, so dass der Chip mit den Kontaktflächen des Leads gegen die Innenseite des Spritzwerkzeugs gesaugt wird. Die Noppen verhindern ein Verrutschen des Chips aus der vorgesehenen Lage in dem herzustellenden Kartenkörper.

Der Erfindung liegt die Aufgabe zugrunde, eine andere Möglichkeit anzugeben, wie die Kunststoff-Flash-Bildung auf den Kontaktflächen der Leads vermieden werden kann.

Diese Aufgabe wird durch einen Systemträger nach Anspruch 1 gelöst.

Die Erfindung sieht vor, jeden Lead mit einem Federelement zu versehen, welches beim Spritzgießen des Gehäuses durch das Spritzwerkzeug stauchbar ist, wobei durch die dabei entstehende Kraft des gestauchten Federelementes die Kontaktflächen der Leads gegen die Innenwand des Spritzwerkzeuges preßbar

Die erfindungsgemäßen Federelemente machen den Einsatz der vom Stand der Technik bekannten Niederhaltestifte unnötig. Damit entfallen die damit verbundenen Nachteile einer komplexeren Handhabbarkeit des Spritzwerkzeuges und es werden die nach der Entfernung der Niederhaltestifte entstehenden Löcher im Spritzgußgehäuse vermieden. Trotzdem werden durch die Erfindung aufgrund der Fixierung der Kontaktfläche und damit des Leads eine Flash-Bildung auf den Kontaktflächen sowie eine Verformung der Leads beim Einspritzen der Kunststoffmasse in das Spritzwerkzeug vermieden.

Ist das Federelement hakenförmig ausgebildet, ist gleichzeitig eine Verankerung des Leads im Gehäuse erreichbar. Somit kann ein Herauslösen des Leads bzw. der Kontaktfläche durch mechanische oder thermische Belastung des fertiggestellten Gehäuses vermieden werden.

Die Erfindung wird im folgenden anhand der Zeichnung erläutert. Es zeigen:
- Figuren 1A bis 4: ein erstes Ausführungsbeispiel des erfindungsgemäßen Systemträgers und verschiedene Schritte der Gehäuseherstellung für eine mit diesem verbundene integrierte Schaltung.
- Figuren 5 und 6: weitere Ausführungsbeispiele des erfindungsgemäßen Systemträgers.

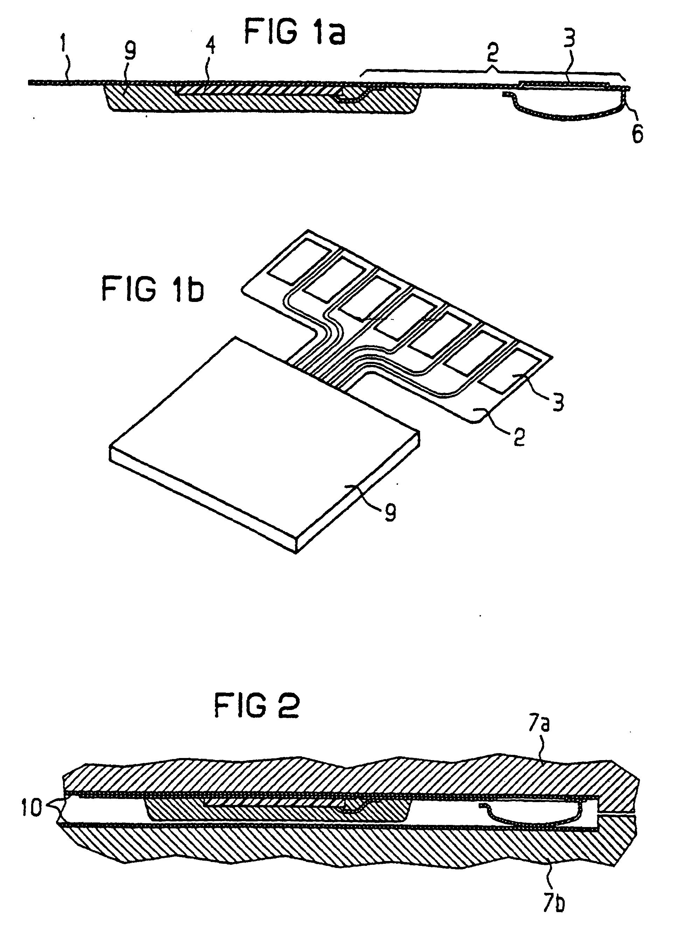

Figur 1A zeigt einen Systemträger 1 (ein sogenannter Leadframe) in einer seitlichen Schnittdarstellung. Er weist Leads 2 auf, von denen in Figur 1A aufgrund der Darstellung nur einer sichtbar ist. Mit dem Systemträger 1 ist eine integrierte Schaltung 4 verbunden, welche zum Schutz mit einer Umhüllung 9 versehen ist, die für gewöhnlich aus einem Duroplasten besteht (Moldkörper). Die Umhüllung 9 befindet sich nur auf einer Seite des Systemträgers 1.

Figur 1B zeigt den Gegenstand aus Figur 1A in einer perspektivischen Darstellung. Gezeigt ist wiederum die Umhüllung 9 und eine Vielzahl von Leads 2, die jeweils eine Kontaktfläche 3 für eine spätere externe Kontaktierung der integrierten Schaltung von außerhalb eines noch herzustellenden Spritzgußgehäuses dienen. Im folgenden wird die Erfindung anhand eines der Leads 2 erläutert, wobei es selbstverständlich ist, daß sämtliche Leads des Systemträgers 1 in gleicher Weise gestaltet sein können.

Figur 1A ist zu entnehmen, daß der Lead 2 an seinem aus der Umhüllung 9 herausragenden Ende so ausgebildet ist, daß ein in etwa halbkreisförmiges Federelement 6 entsteht. Dabei entsteht die federnde Wirkung durch Druck von unten auf das Federelement 6 in Richtung der Kontaktfläche 3 (Figur 1A). Es ist besonders günstig, wenn das Federelement 6 in der Nähe der Kontaktfläche 3 angeordnet ist, wie in Figur 1A gezeigt. Denn dann überträgt sich eine auf das Federelement 6 ausgeübte Kraft optimal auf die Kontaktfläche 3. Nachfolgend wird zur Erklärung der Funktion des Federelementes 6 ein Herstellprozeß für ein Spritzgußgehäuse für die integrierte Schaltung 4 mit dem Systemträger 1 erläutert.

Figur 2 zeigt den Gegenstand aus Figur 1A nachdem er in ein Spritzwerkzeug 7a, 7b mit einer oberen Werkzeughälfte 7a und einer unteren Werkzeughälfte 7b eingebracht worden ist. Dabei sind die beiden Werkzeughälften 7a, 7b des Spritzwerkzeuges noch nicht vollständig geschlossen, so daß auf das Federelement 6 noch keine Kraft ausgeübt wird. Ein mögliches Herstellungsverfahren eines Spritzgußgehäuses ist das sogenannte In-Mold-Labeling, welches hier erläutert wird. Dabei sind zwei gegenüberliegende Innenflächen des Spritzwerkzeuges 7a, 7b mit je einer thermoplastischen Dekorfolie 10 versehen, zwischen die beim Zusammenfügen des Spritzwerkzeuges 7a, 7b der Systemträger 1 mit dem Chip 4 und der Umhüllung 9 eingebracht wird. Figur 2 ist deutlich zu entnehmen, daß bei diesem Ausführungsbeispiel der Erfindung in vorteilhafter Weise das Federelement 6 einen Überstand gegenüber der Dicke der Umhüllung 9 aufweist. Daher ist die untere Werkzeughälfte 7b bereits im Kontakt mit dem Federelement 6, aber noch nicht mit der Umhüllung 9. Wie nachfolgend noch zu sehen ist, entspricht die Dicke der Umhüllung 9, abgesehen von den Dekorfolien 10, genau der Dicke des herzustellenden Spritzgußgehäuses. Daher weist das Federelement 6 also einen Überstand gegenüber der Dicke des herzustellenden Spritzgußgehäuses auf.

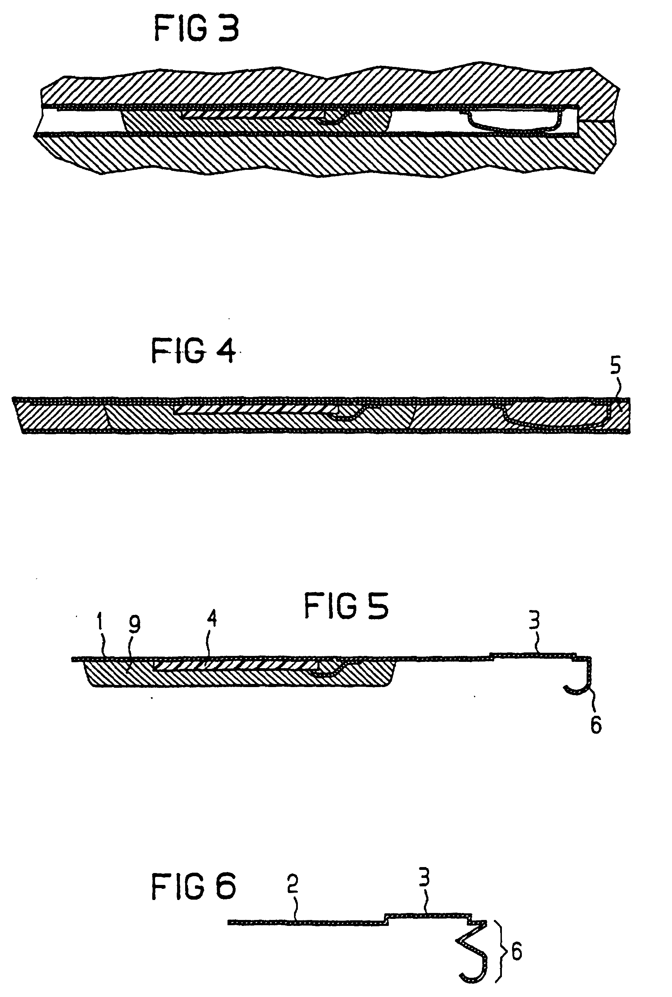

Figur 3 zeigt das Spritzwerkzeug 7a, 7b nach dem endgültigen Zusammenfügen. Durch den Überstand des Federelementes 6 ist dieses beim Zusammenfügen gestaucht worden. Durch die hierdurch hervorgerufene Federkraft wird die Kontaktfläche 3 gegen eine Innenwand 8 der oberen Werkzeughälfte 7a gedrückt. Beim nun folgenden Einspritzen einer thermoplastischen Kunststoffmasse in den verbleibenden Hohlraum des Spritzwerkzeuges 7a, 7b ist durch das Federelement 6 gewährleistet, daß die Kontaktfläche 3 an ihrer Oberseite, die einer späteren externen Kontaktierung der integrierten Schaltung dient, plan auf der Innenwand 8 aufliegt, so daß zwischen beide keine Kunststoffmasse gelangen kann.

Figur 4 zeigt das fertiggestellte Spritzgußgehäuse 5 nach Entfernen des Spritzwerkzeuges 7a, 7b. Der Figur 4 ist zu entnehmen, daß die Oberseite der Kontaktfläche 3 frei von Kunststoff ist. Ferner wird durch die Federkraft des gestauchten Federelementes 6 der Lead 2 während des Einspritzvorgangs gehalten bzw. fixiert, so daß eine Verformung des Leads 2 während der Gehäuseherstellung vermieden wird. Ein weiterer Vorteil des erfindungsgemäßen Federelementes 6 ist, daß durch seine Formgebung eine Verankerung des Leads 2 im Spritzgußgehäuse 5 erfolgt. Dies bedingt, daß auch bei Auftreten von Biege- oder Torsionsbelastungen des Spritzgußgehäuses 5 ein Herauslösen der Kontaktfläche 3 aus dem Gehäuse 5 vermieden wird. Ist das Federelement 6, wie beim Ausführungsbeispiel erläutert, Teil des Leads 2, so wird ein möglicherweise unerwünschter weiterer Kontakt an der Unterseite des Gehäuses 5 über das Federelement 6 durch Vorhandensein der unteren Dekorationsfolie 10 verhindert, die das Federelement 6 nach unten abdeckt.

Figur 5 zeigt ein anderes Ausführungsbeispiel der Erfindung, bei dem das Federelement 6 wiederum Bestandteil des Leads 2 und in unmittelbarer Nähe der Kontaktfläche 3 angeordnet ist. Dabei ist das Federelement nicht halbkreisförmig sondern J-förmig ausgebildet. Auch bei dieser einfacher herzustellenden Ausführungsform der Erfindung werden die gleichen Vorteile, wie oben beschrieben, erzielt: Verhinderung der Flash-Bildung an der Oberseite der Kontaktfläche 3, Verhinderung des Verbiegens des Leads 2 während des Spritzvorganges und Verankerung des Leads 2 und damit der Kontaktfläche 3 im fertiggestellten Spritzgußgehäuse 5.

Die Erfindung eignet sich besonders günstig für die Herstellung sehr dünner Spritzgußgehäuse 5, insbesondere zur Herstellung von Chipkarten oder ähnlichen Gehäusen.

Die Erfindung ermöglicht die Verwendung eines Spritzwerkzeuges ohne verschleißanfällige Niederhaltestifte. Es werden Löcher im fertiggestellten Spritzgußgehäuse vermieden.

Figur 6 zeigt ein weiteres Ausführungsbeispiel der Erfindung. Dargestellt ist nur ein Teil des Systemträgers 1, und zwar ein Teil des Leads 2 mit der Kontaktfläche 3 und dem Federelement 6, das auch bei diesem Ausführungsbeispiel Bestandteil des Leads 2 ist. Dabei ist das Federelement 6 am Ende des Leads 2 zickzackförmig ausgeführt, wodurch ein besonders günstiges federndes Verhalten bewirkt wird. Das Ende des Federelementes 6 ist wieder J-förmig ausgeführt, um eine zusätzliche Verankerung des Leads 2 im fertiggestellten Gehäuse 5 zu erreichen und eine gute Angriffsfläche für das Spritzwerkzeug 7a, 7b zu bieten.

## Patentansprüche

1. Systemträger (1) für die Montage einer integrierten Schaltung (4) in einem Spritzgußgehäuse (5), der wenigstens einen Lead (2) aufweist, der eine Kontaktfläche (3) zur Kontaktierung der integrierten Schaltung (4) von außerhalb des Gehäuses (5) aufweist,
**dadurch gekennzeichnet, dass**
wenigstens einer der Leads (2) ein Federelement (6) aufweist, das so angeordnet ist, dass es beim Spritzgießen des Gehäuses (5) durch ein Spritzwerkzeug (7a, 7b) gestaucht wird, wodurch die Kontaktfläche (3) gegen eine Innenwand (8) des Spritzwerkzeugs (7a, 7b) gepresst wird.

2. Systemtrager nach Anspruch 1,
bei dem ein Ende des Leads (2) zum Federelement (6) ausgebildet ist.

3. Systemträger nach einem der vorstehenden Ansprüche,
bei dem das Federelement (6) hakenförmig ausgebildet ist, so daß nach Fertigstellung des Gehäuses (5) der Lead (2) darin verankert ist.

4. Systemträger nach Anspruch 3,
bei dem das Federelement (6) J-förmig ausgebildet ist.

5. Systemträger nach Anspruch 3,
bei dem das Federelement (6) halbkreisförmig ausgebildet ist.

6. Systemträger nach einem der vorstehenden Ansprüche,
bei dem das Federelement (6) wenigstens teilweise zickzackförmig ausgebildet ist.

7. Systemträger nach einem der vorstehenden Ansprüche,
bei dem das Federelement (6) so angeordnet ist, dass es durch Zusammenfügen zweier Teile des Spritzwerkzeugs (7a, 7b) gestaucht wird,
wobei das Federelement (6) einen Überstand gegenüber der Dikke des Gehäuses (5) aufweist.

## Claims

1. Lead frame (1) for the installation of an integrated circuit (4) in an injection-moulded package (5),
- which has at least one lead (2), which has a contact surface (3) for electrically bonding the integrated circuit (4) from outside the package (5),
- **characterized in that** at least one of the leads (2) has a spring element (6), which is arranged such that it is compressed during the injection moulding of the package (5) by an injection mould (7a, 7b), as a result of which the contact surface (3) is pressed against an inside wall (8) of the injection mould (7a, 7b).

2. Lead frame according to Claim 1, in which one end of the lead (2) is designed to form the spring element (6).

3. Lead frame according to one of the preceding claims, in which the spring element (6) is designed in the form of a hook, so that after completion of the package (5), the lead (2) is anchored therein.

4. Lead frame according to Claim 3, in which the spring element (6) is designed in the form of a J.

5. Lead frame according to Claim 3, in which the spring element (6) is designed in the form of a semicircle.

6. Lead frame according to one of the preceding claims, in which the spring element (6) is designed at least partially in the form of a zigzag.

7. Lead frame according to one of the preceding claims, in which the spring element (6) is arranged such that it is compressed by fitting together two parts of the injection mould (7a, 7b), the spring element (6) projecting beyond the thickness of the package (5).

## Revendications

1. Grille (1) de connexion pour le montage d'un circuit (4) intégré dans un boîtier (5) moulé par injection,
qui comporte au moins un lead (2), qui a une surface (3) de contact pour mettre en contact le circuit (4) intégré de l'extérieur du boîtier (5),
**caractérisée en ce qu'**au moins l'un des leads (2) comporte un élément (6) élastique disposé de façon que, lors du moulage par injection du boîtier (5), il est comprimé par un outil (7a, 7b) de moulage par injection, la surface (3) de contact étant pressée sur une paroi (8) intérieure de l'outil (7a, 7b) de moulage par injection.

2. Grille de connexion suivant la revendication 1,
dans laquelle une extrémité de lead (2) est constituée en élément (6) élastique.

3. Grille de connexion suivant l'une des revendications précédentes,
dans laquelle l'élément (6) élastique est en forme de crochet de manière que le lead (2) s'y accroche après fabrication du boîtier (5).

4. Grille de connexion suivant la revendication 3,
dans laquelle l'élément (6) élastique est en forme de J.

5. Grille de connexion suivant la revendication 3,
dans laquelle l'élément (6) élastique est en forme de demi-cercle.

6. Grille de connexion suivant l'une des revendications précédentes,
dans laquelle l'élément (6) élastique est au moins en partie en forme de zigzag.

7. Grille de connexion suivant l'une des revendications précédentes,
dans laquelle l'élément (6) élastique est disposé de façon à être comprimé par l'assemblage de deux parties de l'outil (7a, 7b) de moulage par injection,
l'élément (6) élastique dépassant par rapport à l'épaisseur du boîtier (5).
